# EUROPEAN PATENT APPLICATION

(11) **EP 1 793 466 A2**
(43) Date of publication of application: **06.06.2007**
(21) Application number: 06010637.4
(22) Date of filing: 24.05.2006
(51) Int. Cl.: H02H 3/347, H02H 3/33

(54) **Circuit-breakers incorporating residual current protection**

(30) Priority: 30.11.2005 JP 2005345857
(71) Applicant: MITSUBISHI DENKI KABUSHIKI KAISHA, Chiyoda-ku, Tokyo 100-8310 (JP)
(72) Inventor: Kamitani, Shintaro, Chiyoda-ku Tokyo 102-0073 (JP)
(74) Representative: HOFFMANN EITLE

(57) **Abstract**

Three-pole circuit-breakers incorporating residual current protection is provided of which not only an earth leakage detecting function but also the function of an earth leakage current test device can be made to work normally whichever phase of a 3-phase circuit fails, without its construction being made complicated. In circuit-breakers incorporating residual current protection having a zero phase current transformer 5 with the three power lines 3 of a 3-phase circuit passing through it, for detecting an earth leakage current of the 3-phase circuit, an earth leakage detecting circuit 7 for performing a level determination on a signal outputted by this zero phase current transformer 5, an electromagnetic device 8 for responding to the output of this earth leakage detecting circuit 7 by opening circuit contacts 4, and an earth leakage current test device 12, to be operated at the time of an earth leakage test, for passing a test current through the zero phase current transformer 5, the earth leakage detecting circuit 7 and the electromagnetic device 8 receive a supply of operating power from the three power lines 3 of the 3-phase circuit by way of a rectifier circuit 10 and the earth leakage current test device 12 is connected to the output terminals of the rectifier circuit 10.

## Description

### BACKGROUND OF THE INVENTION

### 1. Field of the Invention

This invention relates to circuit-breakers incorporating residual current protection for, when an earth leakage current of a circuit rises above a predetermined value, opening this circuit, and particularly to improvement of an earth leakage current test device for checking the functioning of the circuit-breakers incorporating residual current protection.

### 2. Description of Related Art

At present, almost all available circuit-breakers incorporating residual current protection employ an approach whereby with an earth leakage detecting circuit, for example consisting of an integrated circuit, built into the circuit-breakers incorporating residual current protection, a level determination of a signal detected with a zero phase current transformer is carried out, and if it rises above a predetermined value a drive signal is outputted to an electromagnetic device built into the circuit-breakers incorporating residual current protection to open the circuit.

However, the earth leakage detecting circuit and the electromagnetic device need operating power, and this operating power has been taken from inside the circuit-breakers incorporating residual current protection (for example circuit voltage AC400V) and lowered to a predetermined voltage (for example DC12V) before being supplied to them.

At this time, in 3-pole circuit-breakers incorporating residual current protection, of the three poles (for convenience they will be called the R-phase, the S-phase and the T-phase; that is, the S-phase corresponds to a neutral pole), it is usual to take from the outer two poles, i.e. across the R-T phases, and this gives rise to a connection across the R-T phases which is a restricting condition on using 3-pole circuit-breakers incorporating residual current protection in a single-phase circuit.

Now, the internationalization of electricity distribution equipment, so-called global standardization, including these circuit-breakers incorporating residual current protection, has been a topic for some time. Specifically, circuit-breakers incorporating residual current protection conforming to JIS (Japan Industrial Standard) C8201-2-2 based on IEC (International Standard) 60947-2 Annex B are called for.

One difference between this and the old JIS C8371 (i.e. the Japanese standard) is that an earth leakage detecting function must operate normally even when one of the phases of the 3-phase circuit has failed.

Accordingly, when as mentioned above the voltage is taken from across the R-T phases, although there is no problem with an S-phase failure, when the R-phase or the T-phase fails, the earth leakage detecting function is lost immediately.

A known way of preventing this earth leakage detecting function loss is to take operating power from each phase of the 3-phase circuit, rectify it with a rectifying circuit, and lower it to a predetermined voltage.

With this approach, even when one phase fails, operating power can be generated with the remaining two phases, and the earth leakage detecting function can continue normally.

And, there is also the ripple effect that when the circuit-breakers incorporating residual current protection are used in a single-phase circuit, the S-phase does not necessarily have to be avoided; that is, it is possible to connect across the R-S phases or across the S-T phases (see for example Patent Document 1).
Patent Document 1: JP-A-2004-15961 (page 2 lines 48 to 50, Fig. 1)

On the other hand, in a circuit-breakers incorporating residual current protection, irrespective of differences in the standards (numbers), it is stipulated that an earth leakage current test device for testing whether or not the earth leakage detecting function is working normally must be provided.

This earth leakage current test device, as is also clear from Fig. 1 of Patent Document 1, is constructed by a lead wire passed through (or wound around) a zero phase current transformer being connected across the R-T phases by way of a test switch (TS) and a resistor device, and by pushing the TS so that a simulated earth leakage current flows through the zero phase current transformer it is possible to ascertain whether or not the earth leakage detecting function is working.

Here, because as mentioned above the earth leakage current test device is connected across the R-T phases, when the R-phase or the T-phase fails, this test does not function.

Although this earth leakage detection test function at a time of phase failure is not stipulated in either of the standards, the troublesomeness of for example printing a warning note to this effect on the product is undeniable.

As means for realizing an earth leakage detection test function during a phase failure, it is theoretically conceivable to provide an earth leakage current test device on three phases, i.e. across the R-S phases and the S-T phases in addition to across the R-T phases, and make the TS a 3-way contact switch; however, this would lead to increased volume or increased cost of the earth leakage current test device itself, and when the lowness of the probability of performing an earth leakage test during a phase failure is considered it cannot be said to be a realistic solution.

And, when use in a single-phase circuit is considered again, with connection across the R-S phases, or across the S-T phases, measures such as printing the above-mentioned warning note or, as in the past, limiting to connection across the R-T phases, become necessary, and particularly in the usability aspect no improvement has been made.

### SUMMARY OF THE INVENTION

This invention was made to solve the kinds of problem described above, and it is an object of the invention to provide 3-pole circuit-breakers incorporating residual current protection of which not only an earth leakage detecting function but also the function of an earth leakage current test device can be made to work normally whichever phase of a 3-phase circuit fails, without its construction being made complicated.

To achieve this and other objects, the invention provides circuit-breakers incorporating residual current protection having a zero phase current transformer with the three power lines of a 3-phase circuit passing through it, for detecting an earth leakage current of the 3-phase circuit, an earth leakage detecting circuit for performing a level determination on a signal outputted by this zero phase current transformer, an electromagnetic device for responding to the output of this earth leakage detecting circuit by opening circuit contacts, and an earth leakage current test device, to be operated at the time of an earth leakage test, for passing a test current through the zero phase current transformer, wherein the earth leakage detecting circuit and the electromagnetic device receive a supply of operating power from the three power lines of the 3-phase circuit by way of a rectifier circuit and the earth leakage current test device is connected to the output terminals of the rectifier circuit.

With circuit-breakers incorporating residual current protection according to the invention, an earth leakage detection test function during a phase failure can be realized without its construction being made complicated, and combined with the elimination of a restricting condition of use in a single-phase circuit, it is possible to provide a user with 3-pole circuit-breakers incorporating residual current protection with good ease of use without increased cost.

### BRIEF DESCRIPTION OF THE DRAWINGS

Fig. 1 is an internal connection diagram of 3-pole circuit-breakers incorporating residual current protection in a first embodiment of the invention;
Figs. 2A to 2C are views showing waveforms of parts of the 3-pole circuit-breakers incorporating residual current protection in the first embodiment of the invention when it is connected in a 3-phase circuit;
Figs. 3A to 3C are views showing waveforms of parts of the 3-pole circuit-breakers incorporating residual current protection in the first embodiment of the invention when it is connected in a single-phase circuit;
Fig. 4 is an internal connection diagram of 3-pole circuit-breakers incorporating residual current protection in a second embodiment of the invention;
Figs. 5A to 5C are views showing waveforms of parts of the 3-pole circuit-breakers incorporating residual current protection in the second embodiment of the invention when it is connected in a 3-phase circuit; and
Figs. 6A to 6C are views showing waveforms of parts of the 3-pole circuit-breakers incorporating residual current protection in the second embodiment of the invention when it is connected in a single-phase circuit.

### DESCRIPTION OF THE PREFERRED EMBODIMENTS

### First Embodiment

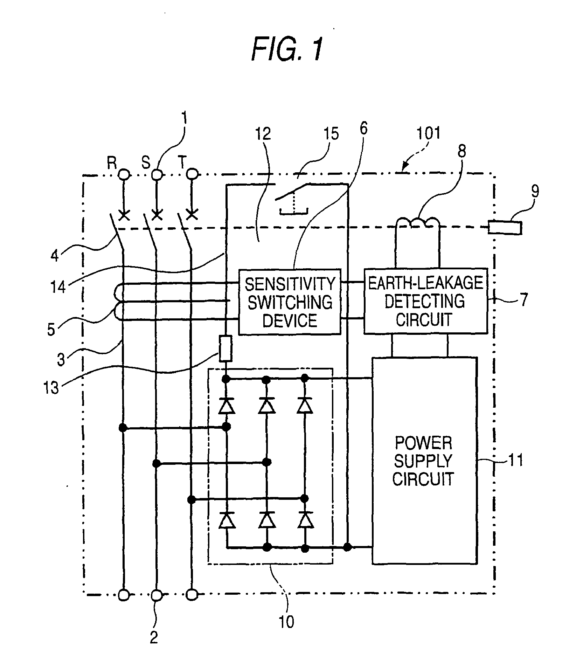

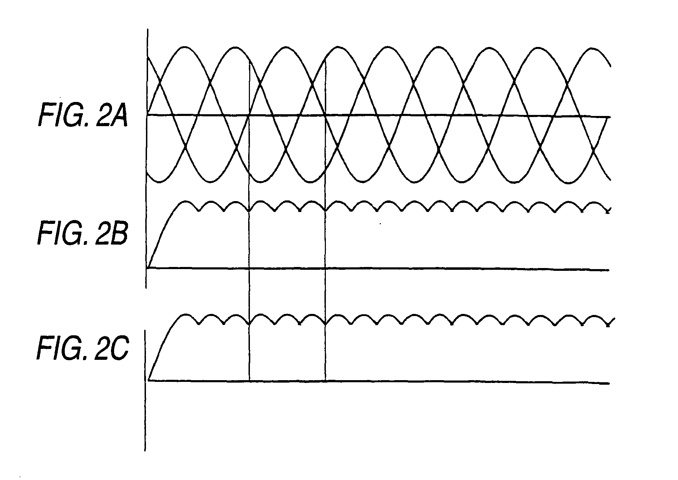

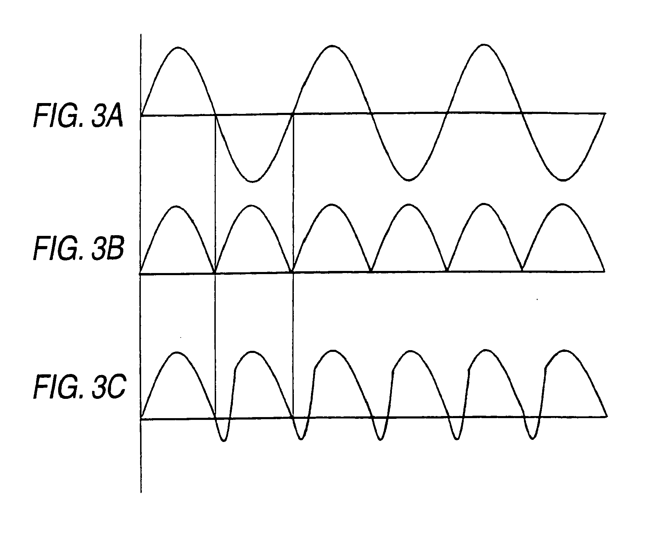

Fig. 1 is an internal connection diagram of 3-pole circuit-breakers incorporating residual current protection in a first embodiment of the invention and Figs. 2A to 2C and Figs. 3A to 3C are views showing waveforms at different points, Figs. 2A to 2C being the case of connection to a 3-phase circuit and Figs. 3A to 3C that of connection to a single-phase circuit.

In Figs. 2A through 3C, the appended letter A indicates the circuit waveform, B the simulated earth leakage current waveform, and C the output waveform of a zero phase current transformer.

In Fig. 1, 3-pole circuit-breakers incorporating residual current protection (hereinafter called the circuit-breakers incorporating residual current protection) 101 has for each of three phases a power supply side terminal 1 for a power supply side and a load side terminal 2 for a load side of an electrical circuit in which it is to be installed, and a power line 3 connecting these two terminals via circuit contacts 4 for switching on and off current flowing through this power line 3.

For convenience these power lines 3 have been given the reference symbols R, S, T from the left side to the right side in the figure. The power lines 3 pass through a zero phase current transformer 5 disposed on the load side of the circuit contacts 4 (the lower side in the figure), and when a balance of the currents flowing through the power lines 3 breaks down, that is, when an earth leakage current from the circuit to ground occurs, a signal proportional to the level of the earth leakage current is outputted from this zero phase current transformer 5.

The signal from the zero phase current transformer 5 is voltage-converted by a resistance (not shown) provided in a sensitivity switching device 6 and fed to an earth leakage detecting circuit 7. This earth leakage detecting circuit 7 detects the height or width of the voltage fed to it, and when determining that it exceeds a predetermined level outputs a signal for exciting an electromagnetic device 8. When the electromagnetic device 8 is excited, for example a rod of an opening and closing mechanism part (not shown) is drawn in, and although the details will not be explained here the circuit contacts 4 are opened and fire or personal injury resulting from earth leakage current are prevented and an earth leakage indication button 9 is made to project from an insulating casing (not shown) of the circuit-breakers incorporating residual current protection 101 so that it can be seen from outside that an earth leakage current has occurred in the circuit.

The sensitivity switching device 6 is utilized in accordance with the purpose of the protection when wanting to change the sensitivity level of the protection (for example from 100mA to 500mA) or when wanting to achieve harmonization of two or more circuit-breakers incorporating residual current protection 101. The earth leakage detecting circuit 7 is usually an integrated circuit.

The earth leakage detecting circuit 7 and the electromagnetic device 8 naturally require operating power, and this is obtained by impressing on a power supply circuit 11 the output of a so-called full-wave rectifier circuit 10 made by connecting to the R-phase, T-phase and S-phase connection points of three pairs of two diodes connected in series and connecting together the ends of the pairs of diodes, that is, their anode sides and cathode sides, and smoothing and lowering it to a predetermined voltage value (for example DC12V) with the power supply circuit 11.

Accordingly, as in Patent Document 1, whichever phase suffers phase failure, because a predetermined value is outputted from the power supply circuit, the earth leakage detecting function is not impaired. The sensitivity switching device 6, the earth leakage detecting circuit 7, the full-wave rectifier circuit 10 and the power supply circuit 11 are mounted on one or more circuit boards.

Next, an earth leakage current test device 12, which is a main part of this invention, will be described.

This earth leakage current test device 12, as in Patent Document 1, is made up of a resistor device 13, an earth leakage test lead wire 14 passed through or wound around the zero phase current transformer 5, and an earth leakage test switch 15, and in that by an earth leakage test button (not shown) connected to the earth leakage test switch 15 being pushed a simulated earth leakage current is made to flow through the zero phase current transformer 5 and leads to excitation of the electromagnetic device 8, it has the same chain of operations as that described above of when an actual earth leakage current occurs.

The choice of passing through or winding onto the zero phase current transformer 5 should be made according to circumstances so that a simulated earth leakage current suited to the sensitivity level of the circuit-breakers incorporating residual current protection 101 is obtained.

A point of this invention lies in the connection position of the earth leakage current test device 12. That is, it can be seen that the earth leakage current test device 12 is connected to the anode side and cathode side connection points, i.e. to the output terminals of the full-wave rectifier circuit. Output waveforms of the zero phase current transformer 5 in this connection will now be described on the basis of Figs. 2A to 2C and 3A to 3C in relation to each of a 3-phase circuit and a single-phase circuit.

When the circuit-breakers incorporating residual current protection 101 is connected in a 3-phase circuit, its circuit waveforms are as shown in Fig. 2A. In this state, if the earth leakage test button is pushed, the waveform of the current flowing through the earth leakage current test device 12 becomes as shown in Fig. 2B, and the output waveform of the zero phase current transformer 5 becomes as shown in Fig. 2C.

On the other hand, when the circuit-breakers incorporating residual current protection 101 is connected in a single-phase circuit, the circuit waveform is as shown in Fig. 3A. In this state, if the earth leakage test button is pushed, the waveform of the current flowing through the earth leakage current test device 12 becomes as shown in Fig. 3B and the output waveform of the zero phase current transformer 5 becomes as shown in Fig. 3C.

That is, as is clear from Fig. 2C and Fig. 3C, because a signal that changes in level continuously is being outputted to the zero phase current transformer 5, even if one phase fails, although a signal corresponding to that phase is not obtained, because, as before, a signal changing in level continues to be outputted, it is possible to perform excitation of the electromagnetic device 8.

As described above, with this first embodiment, in circuit-breakers incorporating residual current protection made up of a zero phase current transformer 5 that has three power lines 3 of a 3-phase circuit passed through it and detects earth leakage current of the 3-phase circuit, an earth leakage detecting circuit 7 for performing level determination of the signal outputted by this zero phase current transformer 5, an electromagnetic device 8 for responding to the output of this earth leakage detecting circuit 7 by disconnecting circuit contacts 4, and an earth leakage current test device 12, to be operated at the time of an earth leakage test, for passing a test current through the zero phase current transformer 5, the earth leakage detecting circuit 7 and the electromagnetic device 8 receive a supply of operating power from the three power lines 3 of the 3-phase circuit by way of a rectifier circuit 10 and the earth leakage current test device 12 is connected to the output terminals of the rectifier circuit 10. Consequently, whichever phase suffers phase failure, the earth leakage detection test function works normally, and because of this, in particular it is not necessary for the user, in carrying out an earth leakage test, to check the state of the circuit (whether or not there is a phase failure) each time.

Also, when the circuit-breakers incorporating residual current protection is connected in a single-phase circuit, because an earth leakage test can be carried out whichever phases it is connected across, 3-pole circuit-breakers incorporating residual current protection with good ease of use can be provided.

Furthermore, because the construction of the earth leakage current test device 12 is unchanged apart from its connection locations, there is no increase in cost. And, because instead of alternating current a full-wave rectified current is passed through the resistor device 13, the load on this resistor device 13 decreases and a small and cheap resistor device with a low resistance to heat can be used.

### Second Embodiment

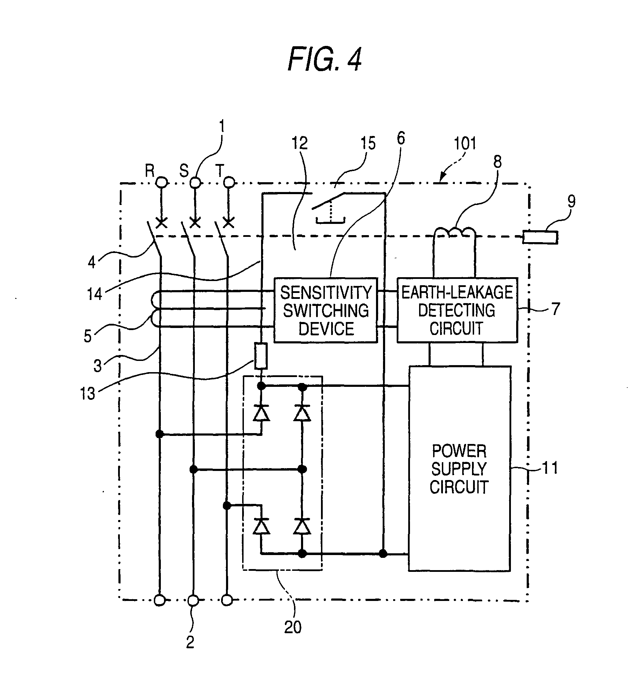

Fig. 4 to Fig. 6C are views corresponding to Fig. 1 to Fig. 3c showing a second embodiment of the invention.

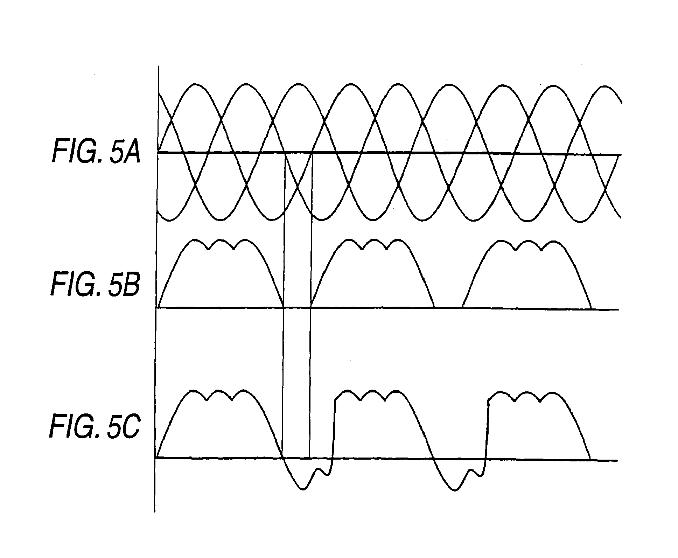

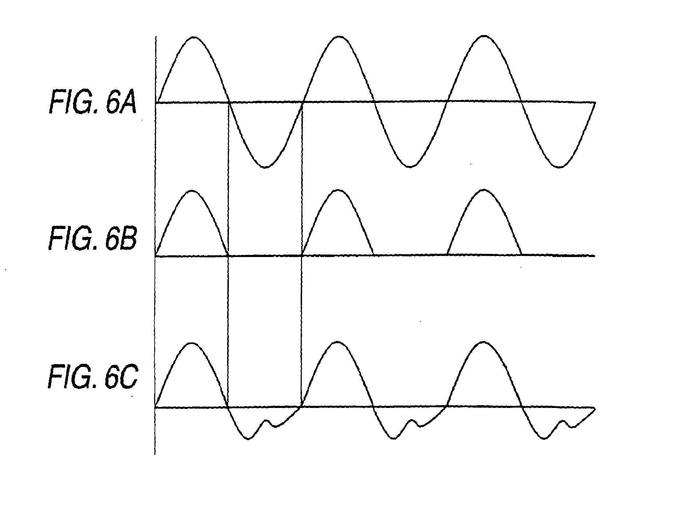

A difference from the first embodiment is that, as shown in Fig. 4, instead of the full-wave rectifier circuit 10, a so-called half-wave rectifier 20 is used, of a constructed wherein, of two pairs of diodes, one pair of diodes has the connection point of its two series-connected diodes connected to the S-phase, the other pair has an anode side connected to the R-phase and a cathode side connected to the T-phase, and at the ends not connected to the power lines 3 the anode sides and the cathodes sides are connected. Output waveforms of the zero phase current transformer 5 in this connection will now be described on the basis of Figs. 5A to 5C and Figs. 6A to 6C in relation to each of a 3-phase circuit and a single-phase circuit, as in the first embodiment.

When the circuit-breakers incorporating residual current protection 101 is connected in a 3-phase circuit, its circuit waveforms are as shown in Fig. 5A. In this state, if the earth leakage test button is pushed, the waveform of the current flowing through the earth leakage current test device 12 becomes as shown in Fig. 5B, and the output waveform of the zero phase current transformer 5 becomes as shown in Fig. 5C.

On the other hand, when the circuit-breakers incorporating residual current protection 101 is connected in a single-phase circuit, the circuit waveform is as shown in Fig. 6A. In this state, if the earth leakage test button is pushed, the waveform of the current flowing through the earth leakage current test device 12 becomes as shown in Fig. 6B and the output waveform of the zero phase current transformer 5 becomes as shown in Fig. 6C.

That is, as in the first preferred embodiment, as is also clear from Fig. 5C and Fig. 6C, because a signal that changes in level continuously is being outputted to the zero phase current transformer 5, even if one phase fails, although a signal corresponding to that phase is not obtained, because, as before, a signal changing in level continues to be outputted, it is possible to perform excitation of the electromagnetic device 8.

In particular, in this half-wave rectification, due to the influence of residual magnetic flux of the zero phase current transformer 5, as shown in Fig. 5C and Fig. 6C, an output is also obtained on the load side (the case of the single-phase circuit in the first embodiment (Fig. 3C) is also the same). Utilizing this output, in addition to the A-type circuit-breakers incorporating residual current protection specified in JIS C8201-2-2 (realizable with the first embodiment), it becomes possible to manufacture also an AC-type circuit-breakers incorporating residual current protection (that is, corresponding to the old JIS C8371 specification).

Although an increase particularly in the attracting force of the electromagnetic device 8 to accompany the earth leakage current test device 12 being driven with a half-wave is necessary, when the point that it is possible to make an AC-type circuit-breakers incorporating residual current protection is considered, it is desirable for the rectifier circuit to be a half-wave rectifier.

In this way, in addition to the effects of the first embodiment, the ripple effects that the variety of product widens and also it is possible to use a resistor device with a small heat resistance can be expected.

## Claims

1. Circuit-breakers incorporating residual current protection having a zero phase current transformer (5) with three power lines (3) of a 3-phase circuit passing through it, for detecting an earth leakage current of the 3-phase circuit, an earth leakage detecting circuit (7) for performing a level determination on a signal outputted by this zero phase current transformer (5), an electromagnetic device (8) for responding to the output of this earth leakage detecting circuit (7) by opening circuit contacts (4), and an earth leakage current test device (12), to be operated at the time of an earth leakage test, for passing a test current through the zero phase current transformer (5), wherein the earth leakage detecting circuit (7) and the electromagnetic device (8) receive a supply of operating power from the three power lines (3) of the 3-phase circuit by way of a rectifier circuit (10) and the earth leakage current test device (12) is connected to the output terminals of the rectifier circuit (10).

2. Circuit-breakers incorporating residual current protection according to claim 1, wherein the rectifier circuit (10) is a full-wave rectifier circuit.

3. Circuit-breakers incorporating residual current protection according to claim 1, wherein the rectifier circuit (10) is a half-wave rectifier circuit.

4. Circuit-breakers incorporating residual current protection according to claim 3, wherein when the earth leakage current test device (12) is operated, the output of the zero phase current transformer (5) appears on both plus and minus sides.

5. Circuit-breakers incorporating residual current protection according to any one of claims 1 through 4, wherein the earth leakage current test device (12) comprises a resistor device (13) connected in series with the output terminals of the rectifier circuit (10), an earth leakage test switch (15), and an earth leakage test lead wire (14) passing through or wound around the zero phase current transformer (5).
